# EUROPEAN PATENT APPLICATION

(11) **EP 0 935 297 A1**
(43) Date of publication of application: **11.08.1999**
(21) Application number: 98400268.3
(22) Date of filing: 06.02.1998
(51) Int. Cl.: H01L 35/08

(54) **A peltier effect thermoelectric module**

(71) Applicant: IMRA EUROPE S.A., F-06560 Valbonne (FR)
(72) Inventor: Ancey, Pascal, 06130 Grasse (FR); Chone, Christophe, 06100 Nice (FR); Fontaine, Jean-Pierre, 06600 Antibes (FR); Gschwind, Michel, 06130 Grasse (FR); Ishihara, Kunio, 06600 Antibes (FR); Boyer, André, 34050 Montpellier (FR); Foucaran, Alain Lot Saint Charles 16, 34130 Mauguio (FR); Giani, Alain, 34920 Le Cres (FR); Pascal-Delannoy, Frédérique, 34000 Montpellier (FR)
(74) Representative: Leszczynski, André

(57) **Abstract**

A Peltier effect thermoelectric module comprising two semiconductor thermoelectric elements respectively of N type and of P type and electrically connected in series is disclosed.

At least one of said elements (2,3) is shaped to offer a tapering section to the flow of current when going towards the other element, said section being less than 3mm² at its minimum. A method of manufacturing the device is also given. In one embodiment the device is used to detect light.

## Description

The present invention relates to a Peltier thermoelectric module comprising two semiconductor thermoelectric elements respectively of N type and of P type, connected electrically in series.

A thermoelectric module of this type is described, for example, in European patent application EP-A-0 613 000 in the name of the Applicant company.

Such a thermoelectric module is used to produce temperature oscillations at the electric junction between the two elements in order to detect a transfer of energy at said junction, e.g. the release of latent heat when condensation forms, for example.

Implementation of a thermoelectric module is subject to various requirements, including the following:
- the thermal capacity of the thermoelectric module at the electric junction between the two elements must not be too great, otherwise the response time performance of the thermoelectric module is degraded;
- ohmic losses in the thermoelectric module which give rise to heat being dissipated by the Joule effect must remain negligible so as to avoid preventing cooling by the Peltier effect;
- the mechanical strength of the thermoelectric module must be sufficient to withstand the mechanical stresses associated with temperature gradients; and
- finally, it is necessary to remove heat efficiently from the ends of the elements remote from the electric junction, since otherwise the performance of the thermoelectric module is degraded.

Known thermoelectric modules are the result of a compromise between those various requirements, and they do not give full satisfaction.

There thus exists a need for a thermoelectric module that presents a response time that is relatively short, with ohmic losses that are relatively small, that is mechanically strong, and that also provides good removal of the heat produced by the elements.

The present invention seeks to further improve thermo-electric modules of the type comprising two semiconductor thermoelectric elements respectively of N type and of P type and electrically connected in series.

The invention achieves this by the fact that at least one of said elements is shaped to offer a tapering section to the flow of current when going towards the other element, said section being less than 3 mm² at its minimum.

In a preferred embodiment of the invention, the two thermoelectric elements together form an hour-glass shape structure.

Each thermoelectric element is then in the form firstly of a narrow section at the electric junction with the other element, thus giving rise to low thermal inertia and short response time, and secondly it is of larger section elsewhere, thus having lower electrical resistance. This decrease in electrical resistance remote from the junction reduces Joule-effect heating without thereby increasing thermal inertia at the junction and degrading the response time performance of the thermoelectric module.

Preferably, the section for passing current through at least one of said thermoelectric elements is at least twice as large at one of its end than at its other end.

In a preferred embodiment, each element is in contact with a current feed tab at its end remote from the other element.

By making each element in this way with its maximum section adjacent to the current feed tab, e.g. twice the section in the vicinity of the electric junction between the elements, heat dissipation via the tab is enhanced and ohmic losses at the interface therewith are further reduced.

The thermoelectric elements are preferably deposited on a substrate by a vacuum deposition technique.

Thus, it is possible to make a large number of thermoelectric modules simultaneously, thereby reducing manufacturing costs.

Finally, the performance of thermoelectric modules of the invention makes it possible to envisage using them for measuring extremely small energy inputs to the electric junction between the elements, such as the energy coming from incident light, for example.

The invention thus also provides the use of a thermoelectric module as specified above for measuring the energy of incident light.

The invention also provides a method of making a Peltier effect thermoelectric module as specified above, characterized by the fact that it comprises the steps consisting in:
- sticking a film of electrically and thermally insulating material on a metal ring;
- using the flash evaporation technique to deposit on said film two semiconductor thermoelectric elements respectively of N type and of P type, the width of the thermoelectric elements over at least a portion of their length, tapering towards the other element;
- depositing a layer of metal that is insoluble in the elements on the narrow ends of the elements, said metal constituting a barrier to chemical diffusion;
- depositing a layer of a second metal on said layer of metal between the narrow ends of the elements; and
- making electrical connections to the elements at their ends remote from their narrow ends.

Other characteristics and advantages of the present invention appear on reading the following detailed description of two non-limiting embodiments of the invention, and on sight of the accompanying drawings, in which:
• Figure 1 is a diagrammatic perspective view of a thermoelectric module constituting a first embodiment of the invention;
• Figure 2 is a fragmentary plan view of the device shown in Figure 1;
• Figures 3 to 8 are diagrams showing various steps in a method of making the thermoelectric module shown in Figure 1 ;
• Figure 9 is a diagram showing a thermoelectric module constituting a second embodiment of the invention.

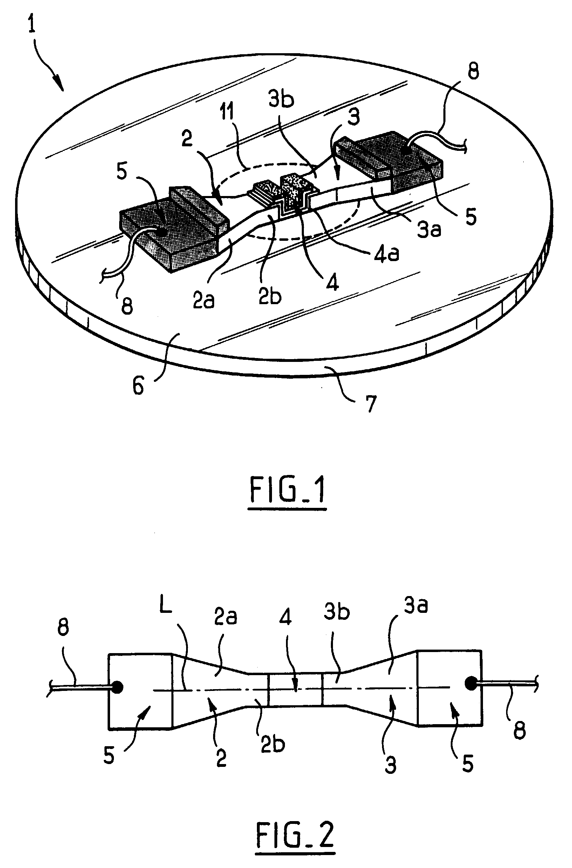

The thermoelectric module 1 shown in Figures 1 and 2 comprises two semiconductor thermoelectric elements 2 and 3 which are respectively of N type and of P type

By way of example, the N-doped thermoelectric element 2 can be made of Bi₂Te₃ and of Bi₂Se₃ while the P-doped thermoelectric element 3 can be made of Bi₂Te₃ and of Sb₂Te₃.

Each thermoelectric element 2 or 3 in the embodiment described is elongate in shape along a common longitudinal axis L and its width tapers linearly from a wide portion 2a or 3a towards the other element, and then remains constant along a narrow portion 2b or 3b.

Each wide portion 2a or 3a is thus trapezium-shaped in plan view.

In the example described, the thickness of each thermo-electric element 2 or 3 is about 20 µm, the width of each element tapers from 600 µm to 300 µm in the wide portion 2a or 3a, the length of each wide portion 2a or 3a is about 1 mm, and the total length of each element 2 or 3 is about 1.5 mm.

In general, in the invention, the current flow section provided by the thermoelectric elements 2 or 3 is less than 3 mm² at its minimum.

An electric junction 4 is formed between the two narrow portions 2b and 3b to connect the elements 2 and 3 electrically in series.

In the example described, this junction 4 is covered in a light-absorbing material so that the thermoelectric module 1 can be used to measure the energy of incident light, as described in greater detail below.

Each wide portion 2a or 3a is in contact at its end remote from the narrow portion 2b or 3b with a respective current feed tab 5.

The assembly constituted by the elements 2 and 3, the junction 4, and the tabs 5 rest on an electrically insulating substrate constituted by a film 6 having its periphery fixed to one of the front faces of a metal ring 7.

By way of example, the film 6 may be constituted by a polyimide.

The junction 4 lies over the central opening 11 of the ring 7. The tabs 5 do not lie over the central opening 11 of the ring 7.

Since the film 6 is very thin, and a good thermal insulator, heat exchange by conduction between the junction 4 and the film remains negligible.

Vacuum is also advantageously created beneath the film 6 in the central region of the ring so as to further improve the thermal insulation of the junction 4.

In the above-described example, the thermoelectric module 1 is made by the following method.

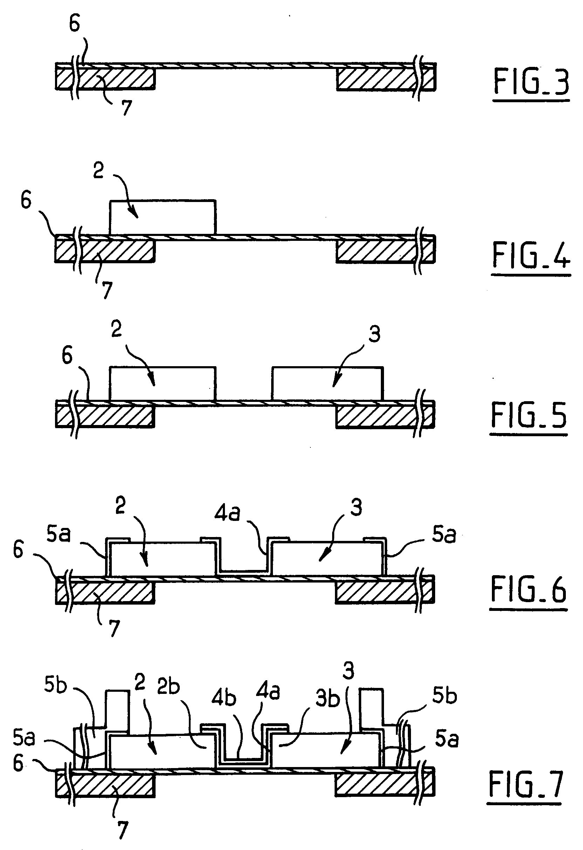

The film 6 is stuck with silver epoxy adhesive on the ring 7, as shown in Figure 3.

Before being stuck in place, the film 6 is stretched bi-axially in its own plane and is annealed at around 300°C to 400°C for about 12 h in order to reduce its tendency to creep.

Thereafter, in a subsequent step shown by Figures 4 and 5, the thermoelectric elements 2 and 3 are deposited successively on the film 6 by a so-called "flash evaporation" technique while using a nickel mask.

This technique consists in using a crucible inside an evacuated enclosure for the purpose of evaporating the material which is to be deposited on a support located inside the enclosure.

The material to be evaporated is delivered in the powder state by means of a source located in a reservoir situated above the crucible, so as to feed the crucible continuously with a small quantity of material.

Using this technique N-doped element 2 is deposited initially by co-evaporation of Bi₂Te₃ and of Bi₂Se₃, and then, after the nickel mask has been moved, the P-doped element 3 is deposited by co-evaporation of Bi₂Te₃ and of Sb₂Te₃.

This is performed in an ultra-vacuum and deposition takes about 15 minutes.

The grain size of the powders used, the distance between the source and the crucible, the distance between the crucible and the film 6, and the temperature of the crucible and that of the substrate are all easily determined by the person skilled in the art as a function of the equipment being used and of the result to be achieved.

Operating conditions are therefore not described in further detail herein, for the purpose of clarifying the present description.

After the elements 2 and 3 have been deposited, the assembly is annealed under an atmosphere containing no air and a flow of hydrogen in order to homogenize the composition of the layers.

Thereafter, as shown in Figure 6, metallization is applied to the axial ends of the elements 2 and 3 by depositing a thin layer of nickel 4a between the narrow portions 2b and 3b and thin layers of nickel 5a at the ends of the wide portions 2a and 3a.

The thickness of the deposited nickel is about 1 µm.

As can be seen in Figure 6, the layers 4a and 5a are deposited not only on the end edges of the elements 2 and 3, but they also overlap them slightly.

The nickel layers 4a and 5a are insoluble in the elements 2 and 3 and they constitute barriers against chemical diffusion.

Thereafter, as shown in Figure 7, a thin layer of copper 4b is deposited between the narrow portions 2b and 3b on the nickel layer 4a between the elements 2 and 3 so as to make the junction 4.

In the example described, the thickness of the layer 4b is 1 µm.

The current feed tabs 5 are also made by depositing a thick layer of copper, with the copper being deposited on the film 6 and overlying the layer 5a of nickel.

In the embodiment described, the layer of copper constituting the tabs 5 is about 20µm thick.

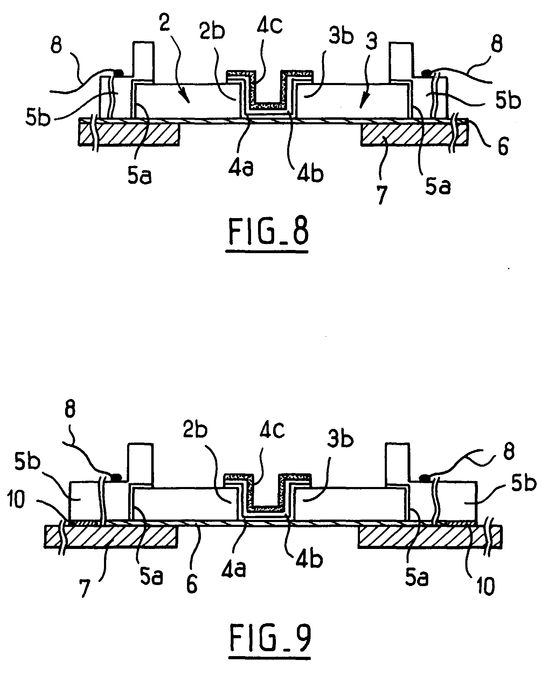

Finally, as shown in Figure 8, a layer 4c of light-absorbing material is deposited on the copper layer 4b, said material being black ink or gold black, for example.

Thereafter, electrical connections are made by bonding conductor wires 8 to the top faces of the tabs 5 using a silver-epoxy bonding agent.

The assembly is then annealed to reduce contact resistances.

From the above description, it will be understood that the thermal capacity of the thermoelectric module in the vicinity of the junction 4 is very low, thereby providing very great reactivity relative to the Peltier effect.

Thus, the temperature of the junction 4 can be varied quickly by means of a very low current passing through the thermoelectric module.

Also, current feed tabs 5 can be made in such a manner as to present relatively high thermal capacity. The performance of the thermoelectric module is improved thereby.

In the embodiment of figure 9 there is a thermally conductive material 10 between the current feed tabs 5 and the ring 7. This material is also electrically insulating. The film 6 does not extend to the area where the material 10 is present.

There are other ways to realize a thermal bridge between current feed tabs 5 and ring 7. For example, the ring 7 can be made of two halves each associated with a respective current feed tab and each half being electrically insulated relative to the other. In this case, the thermally conductive material between a current feed tab 5 and the respective half of the ring can be electrically conductive, for example being made of the same material as the current feed tab 5.

The low thermal inertia presented by the thermoelectric module at the junction 4 makes it possible to envisage using it, specifically as a light meter.

To measure the energy of light falling on the electric junction 4, the temperature of the junction is caused to oscillate, by subjecting the elements 2 and 3 to alternating current.

Any input of energy to the junction 4 due to light lengthens the time required to cool the junction 4 and shortens the time required to heat it. By comparing the heating and cooling times in the absence and in the presence of incident light, it is possible to evaluate quantitatively the energy input due to the light.

Naturally, it would not go beyond the ambit of the present invention to use the thermoelectric module for other applications, e.g. to detect any transfer of energy, for example the formation of condensation, as described in patent application EP-A-0 613 000.

In such circumstances, there is no need to cover the junction 4 in a layer 4c of light-absorbing material.

The transfer of energy detected at the junction can be either positive or negative. A negative transfer of energy occurs for example when the thermoelectric module is used to detect an endothermic reaction at the junction.

Naturally, the invention is not limited to the embodiment described above. In particular, it is possible to make a thermoelectric module of the invention using other techniques that do not require a vacuum.

The varying section of the thermoelectric element as a function of position along its longitudinal axis may be progressive as described above, or may be discontinuous, in the form of steps.

## Claims

1. A Peltier effect thermoelectric module comprising two semiconductor thermoelectric elements respectively of N type and of P type and electrically connected in series, the module being characterized by the fact that at least one of said elements (2, 3) is shaped to offer a tapering section to the flow of current when going towards the other element, said section being less than 3 mm² at its minimum.

2. A module according to claim 1, characterized by the fact that the two thermoelectric elements (2, 3) together form an hour-glass shape structure.

3. A module according to claim 1 or 2, characterized by the fact that said thermoelectric elements (2, 3) are disposed on a substrate (6) by a vacuum deposition technique.

4. A module according to any one of claims 1 to 3, characterized by the fact that said thermoelectric elements are deposited on an electrically and thermally insulating film (6) fixed at its periphery on a ring (7), the electric junction (4) between said thermoelectric elements (2, 3) being situated above an opening (11) of said ring (7).

5. A module according to the preceding claim, characterized by the fact that the thermoelectric elements are in contact with electric current feed tabs (5) located outside the opening of said ring (7).

6. A module according to the preceding claim, characterized by the fact that there is a thermal bridge between said current feed tabs (5) and said ring (7).

7. A module according to any preceding claim, characterized by the fact that the section offered to the flow of current by at least one of said thermoelectric elements is at least twice as great at one of its ends as at its other end.

8. A module according to any preceding claim, characterized by the fact that each thermoelectric element is elongate in shape and of substantially constant thickness, the width of each element tapering linearly towards the other element over a first portion (2a; 3a) of its length, and then remaining constant over a second portion (2b; 3b) of its length.

9. A module according to any preceding claim, characterized by the fact that the electric junction (4) between the thermoelectric elements (2, 3) is covered by a light-absorbing material (4c).

10. The use of a thermoelectric module as defined in any one of claims 1 to 9 for measuring the energy of incident light.

11. A method of making a Peltier effect thermoelectric module as defined above, characterized by the fact that it comprises the steps consisting in:
• sticking a film (6) of electrically and thermally insulating material on a metal ring (7);
• using the flash evaporation technique to deposit on said film (6) two semiconductor thermoelectric elements (2, 3) respectively of N type and of P type, the width of the thermoelectric elements over at least a portion of their length tapering towards the other element;
• depositing a layer (4a) of metal that is insoluble in the elements (2, 3) on the narrow ends of the elements, said metal constituting a barrier to chemical diffusion;
• depositing a layer (4b) of a second metal on said layer of metal (4a) between the narrow ends of the elements; and
• making electrical connections to the elements at their ends remote from their narrow ends.

12. A method according to claim 11, characterized by the fact that prior to being stuck to said ring (7), the film (6) is stretched and annealed.

13. A method according to claim 11 or 12, characterized by the fact that the same mask is used for making each of the elements (2, 3).

14. A method according to any one of claims 11 to 13, characterized by the fact that after the elements (2, 3) have been deposited, the assembly is annealed under an atmosphere containing no air and a flow of hydrogen.
